Europäisches Patentamt

(19) European Patent Office

Office européen des brevets

(11) Numéro de publication: **0 114 540**
**B1**

(12) **FASCICULE DE BREVET EUROPEEN**

(45) Date de publication du fascicule du brevet:
27.08.86

(51) Int. Cl.⁴: **H 03 K 17/04,** H 03 K 17/08

(21) Numéro de dépôt: 83402351.7

(22) Date de dépôt: 06.12.83

(54) Circuit de commande de la base d'un transistor de puissance utilisé en commutation à haute tension.

(30) Priorité: 14.12.82 FR 8220906

(43) Date de publication de la demande:
01.08.84 Bulletin 84/31

(45) Mention de la délivrance du brevet:
27.08.86 Bulletin 86/35

(84) Etats contractants désignés:
BE DE FR GB IT NL SE

(56) Documents cités:
GB - A - 1 396 314
US - A - 3 566 158
US - A - 4 339 671

(73) Titulaire: **LA TELEMECANIQUE ELECTRIQUE, 33 bis, avenue du Maréchal Joffre, F-92000 Nanterre (FR)**

(72) Inventeur: **Gaude, Maurice, Sappey-en-Chartreuse, F-38700 La Tronche (JP)**

(74) Mandataire: **Marquer, Francis, CABINET MOUTARD 35, avenue Victor Hugo Résidence Champfleury, F-78180 Voisins-le-Bretonneux (FR)**

## Description

L'invention se rapporte à un circuit de commande de la base d'un transistor de puissance utilisé en commutation à haute tension.

Dans les hacheurs et les alimentations à découpage de puissance relativement faible, par exemple comprise entre 30 W et 500 W, on utilise couramment un transistor de puissance dont la polarisation collecteur-émetteur Vce est constituée par le secteur alternatif redressé et à la base duquel sont appliquées des impulsions de courant, de fréquence comprise entre 20 et 100 KHz par exemple. Ce transistor fonctionne en régime saturé pendant les impulsions, en régime bloqué dans les intervalles entre impulsions.

Pour augmenter la fréquence de commutation, tout en minimisant les pertes et, lorsque le montage comporte une boucle de régulation, pour obtenir une dynamique de régulation satisfaisante, il importe de minimiser le temps de stockage du transistor, ce qui se fait souvent en faisant comporter au dispositif de commande de base un montage à diodes, dit «anti-saturation», qui permet d'obtenir un état quasi saturé du transistor pendant sa conduction.

A cet effet, on a déjà proposé, notamment par les brevets US 3 566 158 et le brevet GB A 1 396 314, des circuits de commande de base d'un transistor permettant d'obtenir une quasi-saturation du transistor. Toutefois, pour des raisons qui seront expliquées dans la suite, il s'avère souhaitable, dans de tels dispositifs de commande, de prévoir des moyens permettant d'appliquer sur la base du transistor une tension de polarisation inverse pendant le blocage.

Un premier but de l'invention est donc de proposer un circuit de commande d'un transistor, faisant intervenir un transformateur d'impulsions relativement simple, pouvant ne comprendre qu'un seul enroulement primaire et un seul enroulement secondaire et dans lequel une tension de polarisation inverse fournie par le transformateur est appliquée à la base du transistor pendant son blocage.

Pour parvenir à ce résultat, le circuit de commande selon l'invention utilise un transformateur d'impulsions comprenant un enroulement primaire et un enroulement secondaire relié à la base du transistor, au moyen d'un premier dispositif de commutation rendu conducteur pendant la durée des impulsions de manière à obtenir un état quasi saturé du transistor pendant cette durée. Ce circuit est plus particulièrement caractérisé en ce qu'il comprend en outre des moyens de contre-polarisation de ladite base qui comportent au moins une capacité, un circuit de charge de ladite capacité, à partir de l'enroulement secondaire du transformateur, à une tension correspondant à une tension de blocage du transistor, et un circuit de liaison reliant ladite capacité à la base dudit transistor, ce circuit de liaison comprenant un deuxième dispositif de commutation rendu conducteur pendant les intervalles entre les impulsions.

Par ailleurs, l'auto-protection du transistor requiert l'usage de moyens de limitation du courant qui le traverse, donc la comparaison de ce courant à une tension de référence, laquelle est généralement obtenue au moyen d'une source de tension. Lorsque le prélèvement de courant est fait en amont, au niveau de transformateur d'impulsions, le montage est relativement complexe, tel est notamment le cas dans le circuit décrit dans le brevet US 4 339 671 dans lequel la surveillance du courant débité par le transistor est effectuée par un transformateur d'intensité. Il est clair que l'adjonction de tels moyens de limitation de courant, conduit à des montages de commande de base relativement complexes et coûteux.

L'invention a donc également pour but d'intégrer au circuit de commande de base précédemment décrit, un circuit de limitation d'un type beaucoup plus simple et cependant efficace. Ainsi, selon une autre caractéristique de l'invention, ce circuit comporte des moyens pour prélever une tension représentative du courant qui circule dans le transistor, de la comparer à un seuil et d'interrompre la conduction du susdit premier dispositif de commutation en cas de dépassement dudit seuil.

Selon une autre caractéristique de l'invention, la borne de commande du susdit premier dispositif de commutation est connectée à la sortie d'une bascule à mémoire à désarmement dominant dont l'entrée d'armement reçoit les fronts de tension émis par l'enroulement secondaire du transformateur et dont l'entrée de désarmement est reliée à la sortie d'un dispositif à seuil qui reçoit sur l'une de ses entrées une tension continue de seuil et sur son autre entrée une tension représentative du courant circulant dans le transistor.

Selon un mode d'exécution préféré de l'invention, le susdit premier dispositif de commutation comprend un deuxième transistor (le premier transistor étant le transistor de puissance) et la bascule à mémoire à désarmement dominant comprend un troisième transistor relié par son collecteur à la base du deuxième transistor, et dont la base est reliée à son émetteur par l'intermédiaire de la jonction émetteur-collecteur d'un quatrième transistor jouant le rôle d'un comparateur, dont la base est reliée à des moyens de prélever une tension représentative du courant débité par le premier transistor et de comparer ladite tension à sa tension base-émetteur. Par ailleurs, le circuit de charge de la susdite capacité peut avantageusement comprendre une résistance en série avec l'enroulement secondaire du transformateur, et aux bornes de laquelle est monté en parallèle un circuit comprenant en série une diode et ladite capacité. Cette capacité peut en outre être connectée à l'émetteur d'un cinquième transistor agencé pour comparer la tension inverse engendrée par le secondaire du transformateur pendant les intervalles entre les impulsions, à sa propre tension base-émetteur et pour appliquer ladite tension de polarisation négative à la base du premier transistor, pendant lesdits intervalles.

Ainsi, au moyen d'un montage simple, l'invention permet d'obtenir les trois fonctions précédemment mentionnées, à savoir, l'anti-saturation, la génération d'une polarisation de base négative et la limitation du courant débité par le transistor de puissance, à l'aide d'un petit nombre de composants et sans faire appel à des sources de tension accessoires.

D'autres particularités, ainsi que les avantages de l'invention, apparaîtront clairement à la lumière de la description détaillée ci-après.

Au dessin annexé:

la figure 1 est un schéma de principe d'un circuit de commande de la base d'un transistor de puissance utilisé en commutation à haute tension, conforme à l'invention;

la figure 2 représente les formes d'ondes en différents points du circuit de la figure 1; et

la figure 3 représente un mode d'exécution préféré dudit circuit.

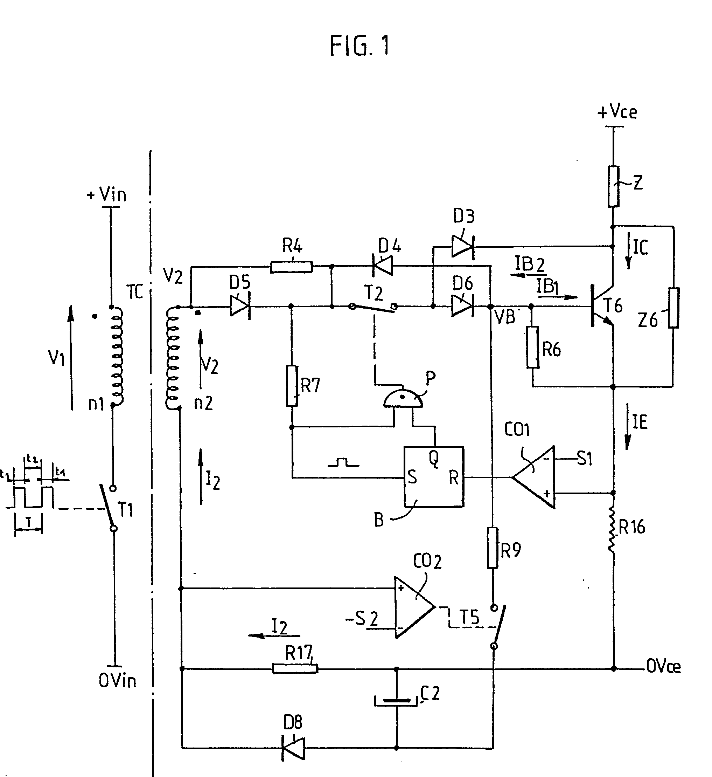

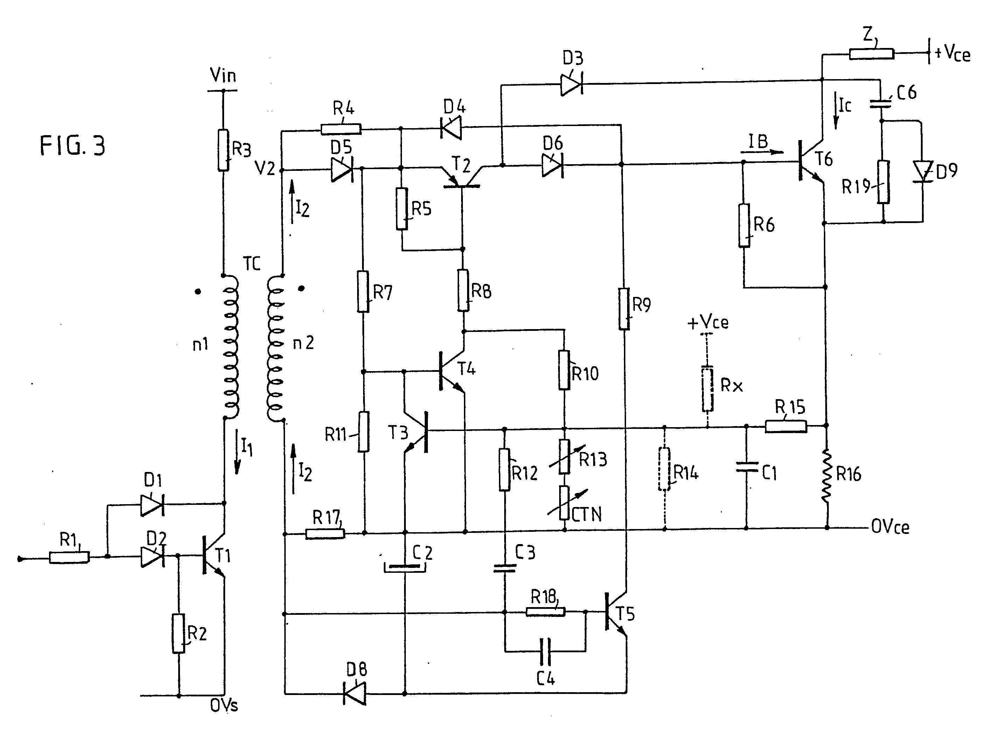

Les mêmes numéros de référence désignent des composants homologues dans les figures 1 et 3.

Le circuit représenté comprend un transistor découpeur de puissance $T_6$ dont il s'agit d'assurer la commande de base, monté entre la borne positive $+V_{ce}$ et la borne de masse $OV_{ce}$ d'une tension continue appropriée, avec une charge Z reliée à son collecteur et une résistance $R_{16}$ de mesure du courant reliée à son émetteur. Un réseau d'aide à la commutation $Z_6$, connu en soi et par exemple constitué d'un condensateur $C_6$ en série avec une résistance $R_{19}$ et d'une diode de $D_9$ en parallèle sur $R_{19}$, figure 3, est branché en parallèle sur le transistor $T_6$.

Les impulsions de commande, de période T, de durée de conduction $t_1$ et de durée de non conduction $t_2$, sont appliquées à un commutateur $T_1$ monté dans l'enroulement primaire $n_1$ d'un transformateur $T_C$ alimenté par une tension continue $V_{in}$.

Dans le mode d'exécution préféré de la figure 3, le commutateur $T_1$ est un transistor bipolaire dont la base reçoit les impulsions de commande par l'intermédiaire d'un pont constitué de résistances $R_1$ et $R_2$; une diode $D_2$ relie la résistance $R_1$ à ladite base, tandis qu'une diode $D_1$ relie le collecteur de $T_1$ au point commun entre $R_1$ et $D_2$. Une résistance $R_3$ est branchée en série avec l'enroulement primaire du transformateur.

Le point chaud de l'enroulement secondaire $n_2$ du transformateur TC est relié à la base du transistor $T_6$ par l'intermédiaire d'une diode $D_5$, d'un commutateur $T_2$ et d'une diode D6. Une diode D3 relie le point commun au commutateur $T_2$ et à la diode $D_6$, au collecteur du transistor $T_6$ et, avec la diode $D_6$, constitue, pour ce dernier transistor $T_6$, un dispositif d'anti-saturation bien connu en soi.

Une résistance $R_6$ relie la base du transistor $T_6$ à son émetteur.

Entre l'anode de la diode $D_6$ et le point chaud de l'enroulement secondaire $n_2$ est branché, en parallèle sur l'ensemble $D_5$ $T_2$ $D_6$, un ensemble série constitué par une diode $D_4$ et une résistance $R_4$.

Par ailleurs, l'enroulement secondaire $n_2$ du transformateur TC se trouve relié, de l'autre côté, à la borne $OV_{ce}$ par l'intermédiaire d'une résistance $R_{17}$ aux bornes de laquelle est monté en parallèle un circuit comprenant, en série, une capacité $C_2$ et une diode $D_8$.

Le commutateur $T_2$ est commandé par une bascule B constituant une mémoire RS à R dominant qui reçoit, sur son entrée d'armement S, le front de tension transmis par la diode $D_5$ et une résistance $R_7$ et dont l'entrée de désarmement R est reliée à la sortie d'un comparateur $CO_1$. L'entrée négative de ce dernier reçoit une tension continue de seuil $S_1$ et, à son

entrée positive, est appliquée la tension $R_{16} \times I_E$ aux bornes d'une résistance $R_{16}$, reliant l'émetteur du transistor $T_6$ à la borne $OV_{ce}$, $I_E$ étant le courant d'émetteur du transistor $T_6$.

Une porte ET, désignée P à la figure 1, a sa sortie reliée à l'entrée de commande du commutateur $T_2$ et ses entrées respectivement reliées à la sortie Q de la bascule B et à la résistance $R_7$.

Un comparateur $CO_2$ a son entrée positive reliée au point de masse de l'enroulement secondaire, tandis qu'à son entrée négative est appliquée une tension continue de seuil $-S_2$. La sortie du comparateur $CO_2$ commande un commutateur $T_5$, relié à l'anode de la diode $D_6$ et à la base du transistor $T_6$ à travers une résistance $R_9$ et à la liaison entre le condensateur $C_2$ et la diode $D_8$.

Dans le mode d'exécution préféré de la figure 3, les commutateurs $T_2$ et $T_5$ sont constitués par des transistors bipolaires et les comparateurs $CO_1$ et $CO_2$, respectivement par un transistor $T_3$ (bipolaire ou MOS) et par le transistor $T_5$, qui joue donc le double rôle de comparateur et de commutateur. Le seuil $S_1$ qui correspond à la tension base-émetteur du transistor $T_3$ est comparé à une tension définie par un pont diviseur de tension monté en parallèle sur la résistance $R_{16}$ et qui comprend une résistance $R_{15}$ reliant l'émetteur du transistor $T_6$ à la base du transistor $T_3$ et un circuit reliant la base du transistor $T_3$ à la borne $OV_{ce}$, ce circuit comprenant, en série, une résistance ajustable $R_{13}$ et une résistance à coefficient de température négatif CTN, choisie pour compenser les variations de la tension base-émetteur du transistor $T_3$ avec la température. Sur ce circuit ($R_{13}$, CTN) sont montées en parallèle une capacité $C_1$ ainsi qu'éventuellement une résistance $R_{14}$ indiqué en traits interrompus.

Par ailleurs, selon un mode particulièrement avantageux de l'invention, la base du transistor $T_3$ peut être en outre reliée, par l'intermédiaire d'une résistance $R_X$, à une borne $+Vce$ portée à une tension représentative de la tension émetteur-collecteur du transistor $T_6$, ce montage ayant pour but de corriger la mesure du courant émetteur du transistor $T_6$ en fonction de l'amplitude de la tension collecteur-émetteur du transistor $T_6$. Ce montage, également représenté en traits interrompus, contribue ainsi à obtenir une limitation de la puissance commutée par le transistor $T_6$, indépendante de la tension d'alimentation par l'intermédiaire de la résistance $R_X$ (le seuil de limitation de courant se trouve asservi à la tension Vce), et indépendante de la température, par le résistance à coefficient de température négatif CTN.

La base du transistor $T_3$ est en outre reliée à la base du transistor $T_5$ par l'intermédiaire d'une résistance $R_{12}$, d'un condensateur $C_3$ et de l'ensemble parallèle constitué par une résistance $R_{18}$ et un condensateur $C_4$, dont le point commun avec le condensateur $C_3$ est relié au point de masse de l'enroulement secondaire.

Le seuil $S_2$ correspond à la tension $V_{BE}$ du transistor $T_5$.

La bascule B de la figure 1 est, à la figure 3, constituée par les deux transistors $T_3$ et $T_4$ rebouclés par la résistance $R_{10}$, tandis que la porte P est constituée

par le transistor $T_4$ et des résistances $R_7$ et $R_5$, $R_8$, branchées comme illustré à la figure 3.

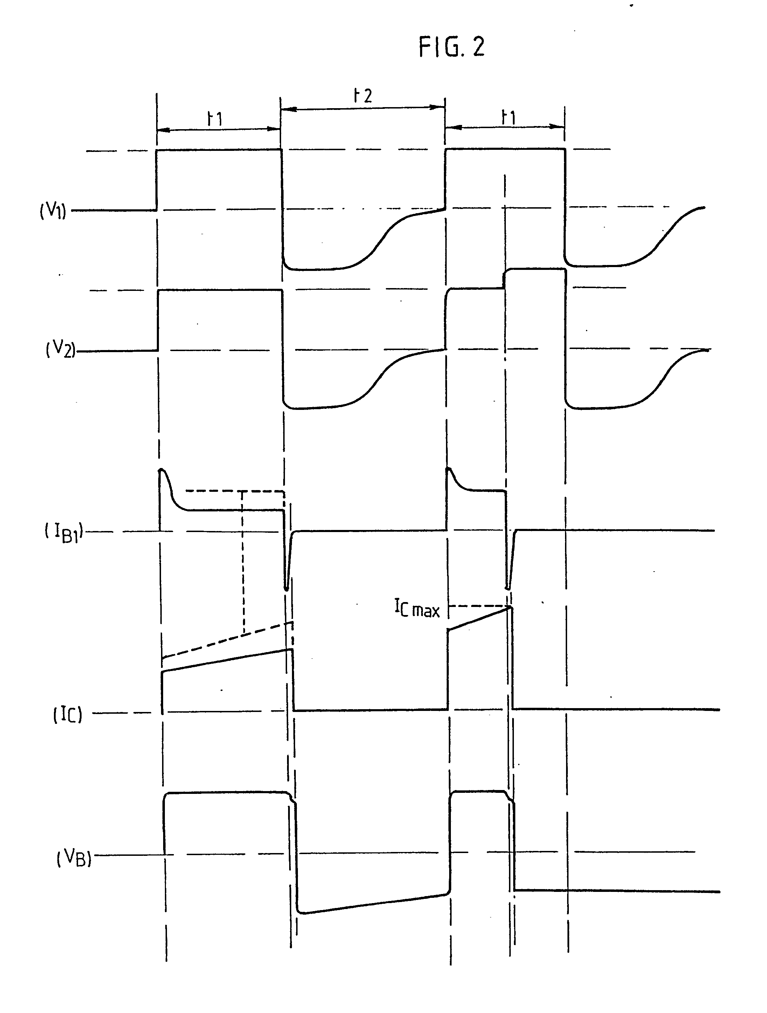

A la figure 2, on a représenté: la tension $V_1$ aux bornes de l'enroulement primaire; la tension $V_2 = V_1 \cdot \dfrac{n_2}{n_1}$ aux bornes de l'enroulement secondaire; le courant $IB_1$ dans la base du transistor $T_6$; le courant $I_c$ dans le collecteur du transistor $T_6$ et la tension $V_B$ de base du transistor $T_6$. La première période $t_1 + t_2$ représentée correspond à un fonctionnement normal; la deuxième période correspond à un fonctionnement en auto-protection.

Le fonctionnement normal est le suivant:

Au début de l'intervalle de temps $t_1$, la tension $V_2$ apparaît aux bornes de l'enroulement secondaire $n_2$ et, par conséquent, la bascule B (figure 1) est positionnée à 1. La sortie de la porte P est donc à 1 et le commutateur $T_2$ se ferme. Le dispositif anti-saturation applique alors un courant $IB_1$ dans la base du transistor $T_6$ de façon à obtenir, comme cela est connu en soi, le maintien du transistor $T_6$ à l'état quasi saturé. Le courant $I_2$ charge le condensateur $C_2$, par la résistance $R_{17}$, et la diode $D_8$, à une tension $-V_p$ de blocage qui servira à polariser la base du transistor $T_6$ en inverse pendant l'intervalle de temps $t_2$. On observe, à cause de cette charge, une pointe du courant $IB_1$ au début de l'intervalle $t_1$ (figure 2).

Cette pointe de courant accélère la mise en conduction du transistor $T_6$.

La sortie du comparateur $CO_2$ est à zéro et, par conséquent, le commutateur $T_5$ est ouvert.

A la fin de l'intervalle $t_1$, la tension $V_2$ s'annule avant de s'inverser et, par conséquent, la sortie de la porte P passe à 0 et le commutateur $T_2$ s'ouvre.

Le courant $I_2$, donc la tension aux bornes de la résistance $R_{17}$, s'inverse, ce qui fait passer la sortie du comparateur $CO_2$ à 1.

Il en résulte que le commutateur $T_5$ se ferme.

Le transistor $T_6$ est à l'état bloqué et sa base est polarisée négativement par la tension $-V_p$, transmise à travers le transistor $T_5$ et la résistance $R_9$. Cette polarisation négative assure l'immunité aux bruits et améliore la tenue en tension à l'état bloqué.

Le courant de base $IB_2$ correspondant aux charges accumulées s'écoule, d'une part à travers le transistor $T_5$ avec une intensité limitée par la résistance $R_9$, d'autre part dans l'enroulement secondaire à travers la diode $D_4$ et la résistance $R_4$, tant que la tension $V_2$ est négative. Une fois le transformateur démagnétisé, $V_2$ revient à zéro. La tension de base du transistor $T_6$ est cependant maintenue négative grâce à la tension $-V_p$.

Le fonctionnement en auto-protection est le suivant:

S'il se produit que le courant d'émetteur $I_E$ du transistor $T_6$ atteint ou dépasse $\dfrac{S1}{R16}$, la sortie du comparateur $CO_1$ passe à 1 et remet à zéro la bascule B. Il en résulte que le transistor $T_2$ s'ouvre immédiatement et que le courant $I_2$ s'annule malgré le maintien de $V_2$ à une valeur positive pendant tout l'intervalle $t_1$.

L'annulation de $I_2$ provoque la fermeture du commutateur $T_5$ et la tension de base du transistor $T_6$, qui est à l'état bloqué, se trouve maintenue à une valeur négative.

Dès que le transistor $T_6$ passe à l'état bloqué, le courant $I_E$ diminue. Pour éviter que le montage limiteur de courant que l'on vient de décrire n'entre en oscillation, il importe donc que l'effet du dépassement de courant d'émetteur soit mémorisé pendant tout le reste de l'intervalle $t_1$. Ce résultat est obtenu grâce au fait que la bascule B est agencée pour rester dans l'état 0 tant qu'un nouveau front montant de tension $V_2$ ne lui est pas appliqué.

Si l'on considère maintenant le montage pratique de la figure 3, dès que la limitation de courant est intervenue, la résistance $R_{12}$ et les condensateurs $C_3$-$C_4$ ont pour effet utile d'accélérer la mise en conduction du transistor $T_5$, donc la mise en polarisation négative de la base du transistor $T_6$. En effet, la résistance $R_{12}$ et le condensateur $C_3$ jouent le rôle d'un différenciateur qui applique une impulsion négative assurant l'existence d'une polarisation négative au début d'un front de descente de l'alternance positive.

La fonction de mémoire de la bascule constituée par les transistors $T_3$, $T_4$ est assurée grâce à la résistance $R_{10}$; en effet, dès que le transistor $T_4$ se bloque, le potentiel de base du transistor $T_3$ prend, grâce au courant à travers les résistances $R_{10}$, $R_{13}$, CTN, une valeur telle que le transistor $T_4$ est maintenu dans l'état bloqué à la mise en conduction du transistor $T_6$. L'action du transistor $T_3$ (qui joue normalement aussi le rôle du comparateur $CO_1$) est donc masquée pendant un court instant (de l'ordre 1 $\mu$s) par le condensateur $C_1$, la résistance $R_{12}$ et le condensateur $C_3$, qui constituent également un filtre passe-bas éliminant les transitoires très rapides, ce qui évite que le transistor $T_4$ ne puisse se bloquer intempestivement sous l'effet des pointes de courant parasites importantes susceptibles de se produire à l'instant de la mise en conduction.

On voit en définitive que l'on a assuré, au moyen d'un montage simple réalisé avec un petit nombre de composants courants et très économiques et un seul transformateur d'impulsions, sans faire appel à aucune source de basse tension positive ou négative, un montage de commande de base comportant un isolement entre le circuit de commande et la charge commutée (transformateur TC) et remplissant de manière efficace les fonctions de minimisation du temps de stockage du transistor découpeur (diodes anti-saturation), d'application d'une polarisation de base négative pendant le blocage (source résistance $R_{17}$, diode $D_8$, condensateur $C_2$, comparateur $CO_2$ et commutateur $T_5$) et d'auto-protection du transistor (résistance de mesure $R_{16}$, comparateur $CO_1$, bascule B et commutateur $T_2$).

**Revendications**

1. Circuit de commande de la base d'un premier transistor de puissance ($T_6$) comportant un transformateur d'impulsions (TC) comprenant un enroulement primaire et un enroulement secondaire relié à la base dudit premier transistor ($T_6$) au moyen d'un premier dispositif de commutation ($T_2$) rendu conducteur pendant la durée des impulsions, de manière à obtenir un état quasi-saturé dudit premier transistor ($T_6$) pendant ladite durée, caractérisé en ce qu'il comprend, en outre, des moyens de contre-polarisation de ladite base, qui comportent au moins une capacité ($C_2$), un circuit de charge de ladite capacité ($C_2$), à partir de l'enroulement secondaire du transformateur (TC), à une tension correspondant à une tension de blocage du premier transistor ($T_6$), et un circuit de liaison reliant ladite capacité ($C_2$) à la base dudit transistor ($T_6$), ce circuit de liaison comprenant un deuxième dispositif de commutation ($T_5$) rendu conducteur pendant les intervalles entre lesdites impulsions.

2. Circuit selon la revendication 1, caractérisé en ce qu'il comporte en outre des moyens ($R_{16}$, $CO_1$, B, P) de prélever une tension représentative du courant qui circule dans ledit premier transistor ($T_6$), de la comparer à un seuil ($S_1$) et d'interrompre la conduction du susdit premier dispositif de commutation ($T_2$) en cas de dépassement dudit seuil ($S_1$).

3. Circuit selon la revendication 1, caractérisé en ce que la borne de commande du susdit premier dispositif de commutation ($T_2$) est connectée à la sortie d'une bascule à mémoire à désarmement dominant (B) dont l'entrée d'armement (S) reçoit les fronts de tension émis par l'enroulement secondaire ($n_2$) du transformateur (TC) et dont l'entrée de désarmement (R) est reliée à la sortie d'un dispositif à seuil ($CO_1$) qui reçoit sur l'une de ses entrées une tension continue de seuil ($S_1$) et sur son autre entrée une tension représentative du courant circulant dans le premier transistor ($T_6$).

4. Circuit selon la revendication 1, caractérisé en ce que le circuit de charge de la susdite capacité ($C_2$) comprend une résistance ($R_{17}$) en série avec l'enroulement secondaire ($n_2$) du transformateur (TC) et aux bornes de laquelle est monté en parallèle un circuit comprenant en série une diode ($D_8$) et ladite capacité ($C_2$).

5. Circuit selon la revendication 3, caractérisé en ce que le susdit premier dispositif de commutation consiste en un deuxième transistor ($T_2$), et en ce que la bascule à mémoire à désarmement dominant (B) comprend un troisième transistor ($T_4$) relié par son collecteur à la base du deuxième transistor ($T_2$) et dont la base est reliée à son propre émetteur par l'intermédiaire de la jonction émetteur-collecteur d'un quatrième transistor ($T_3$) jouant le rôle d'un comparateur, dont la base est reliée à des moyens ($R_{15}$, $R_{16}$) de prélever une tension représentative du courant débité par le premier transistor ($T_6$) et de comparer ladite tension à sa tension base-émetteur.

6. Circuit selon la revendication 1, caractérisé en ce que ladite capacité ($C_2$) est connectée à l'émetteur d'un cinquième transistor ($T_5$) agencé pour comparer la tension inverse engendrée par l'enroulement secondaire ($n_2$) du transformateur (TC) pendant les intervalles entre les impulsions à sa propre tension base-émetteur et pour appliquer ladite tension de polarisation négative à la base du premier transistor ($T_6$) pendant lesdits intervalles.

. Circuit selon la revendication 5, caractérisé en ce que les susdits moyens de prélever une tension représentative du courant du premier transistor ($T_6$) comprennent une résistance ajustable ($R_{16}$) reliée à l'émetteur dudit premier transistor ($T_6$), une deuxième résistance ($R_{15}$) reliant l'émetteur du premier transistor ($T_6$) à la base du quatrième transistor ($T_3$), ainsi qu'un circuit reliant la base du quatrième transistor ($T_3$) à son émetteur, ce circuit comprenant, en série, une résistance ajustable ($R_{13}$) et une résistance à coefficient de température négatif (CTN), choisie pour compenser les variations de la tension base-émetteur dudit quatrième transistor ($T_3$).

8. Circuit selon la revendication 5, caractérisé en ce que la base du quatrième transistor ($T_3$) est reliée par l'intermédiaire d'une résistance ($R_X$) à une borne (+ Vce) portée à une tension représentative de la tension collecteur-émetteur du premier transistor ($T_6$).

9. Circuit selon la revendication 5, caractérisé en ce que la base du quatrième transistor ($T_3$) est reliée par des moyens dérivateurs ($R_{12}$, $C_3$, $C_4$) à la base du susdit cinquième transistor ($T_5$), afin d'accélérer la mise en conduction dudit cinquième transistor ($T_5$) lorsque le quatrième transistor ($T_3$) est lui-même mis en conduction.

10. Circuit selon la revendication 5, caractérisé en ce qu'il comprend une résistance ($R_{10}$) reliant le collecteur du troisième transistor ($T_4$) à la base du quatrième transistor ($T_3$), pour assurer la conduction dudit quatrième transistor ($T_3$) dès que le troisième transistor ($T_4$) cesse de conduire.

**Patentansprüche**

1. Basissteuerschaltung für einen ersten Leistungstransistor ($T_6$) mit einem Impulstransformator (TC), der eine Primär- und eine Sekundärwicklung besitzt, die mit der Basis des besagten ersten Transistors ($T_6$) durch eine erste Schaltvorrichtung ($T_2$) verbunden ist, welche für die Dauer der Impulse leitend wird, um, für besagte Dauer, einen quasi gesättigten Zustand des besagten ersten Transistors ($T_6$) zu erreichen, dadurch gekennzeichnet, dass sie ausserdem Mittel zur Gegenpolarisierung der besagten Basis enthält, mit mindestens einer Kapazität ($C_2$), einem Schaltkreis, um besagte Kapazität ($C_2$) durch die Sekundärwicklung des Transformators (TC) bis zu einer Spannung aufzuladen, die der Spannung zur Blockierung des ersten Transistors ($T_6$) entspricht und einer Verbindungsschaltung, welche besagte Kapazität ($C_2$) mit der Basis besagten Transistors ($T_6$) verbindet, wobei zu dieser Verbindungsschaltung eine zweite Schaltvorrichtung ($T_5$) gehört, die während der Zeiträume zwischen den Impulsen leitend wird.

2. Schaltung nach Anspruch 1, dadurch gekennzeichnet, dass zu ihr ausserdem Mittel ($R_{16}$, $CO_1$, B, P) gehören, um eine Spannung zu entnehmen, die repräsentativ ist für den Strom, der in besagtem ersten Transistor ($T_6$) fliesst, um diese mit einer Schwelle ($S_1$) zu vergleichen und die Leitfähigkeit besagter erster Schaltvorrichtung ($T_2$) zu unterbrechen, wenn besagter Schwellenwert ($S_1$) überschritten wird.

3. Schaltung nach Anspruch 1, dadurch gekennzeichnet, dass die Steuerklemme für besagte erste Schaltvorrichtung (T$_2$) an den Ausgang einer Speicher-Kippschaltung mit dominierender Rückstellung (B) angeschlossen ist, deren Anzugseingang (S) die von der Sekundärwicklung (n$_2$) des Transformators (TC) ausgesandten Spannungsfronten erhält und deren Rückstelleingang (R) an den Ausgang einer Schwellenvorrichtung (CO$_1$) angeschlossen ist, die an einem ihrer Eingänge eine Schwellengleichspannung (S$_1$) erhält und an ihrem anderen Eingang eine Spannung, die repräsentativ ist für den im ersten Transistor (T$_6$) fliessenden Strom.

4. Schaltung nach Anspruch 1, dadurch gekennzeichnet, dass die Schaltung, um besagte Kapazität (C$_2$) aufzuladen, einen mit der Sekundärwicklung (n$_2$) des Transformators (TC) in Reihe geschalteten Widerstand (R$_{17}$) enthält, an dessen Klemmen eine Schaltung mit, in Reihe, einer Diode (D$_8$) und besagter Kapazität (C$_2$) parallel angeschlossen ist.

5. Schaltung nach Anspruch 3, dadurch gekennzeichnet, dass besagte erste Verbindungsschaltung aus einem zweiten Transistor (T$_2$) besteht und dass zur Speicher-Kippschaltung mit dominierender Rückstellung (B) ein dritter Transistor (T$_4$) gehört, welcher durch einen Kollektor an die Basis des zweiten Transistors (T$_2$) angeschlossen ist und dessen Basis an den eigenen Sender durch die Sender-Kollektorverbindung eines vierten Transistors (T$_3$) angeschlossen ist, welcher die Rolle eines Komparators spielt, dessen Basis an Mittel (R$_{15}$, R$_{16}$) angeschlossen ist, um eine Spannung zu entnehmen, die repräsentativ ist für den vom ersten Transistor (T$_6$) ausgegebenen Strom und um besagte Spannung mit der Basis-Senderspannung zu vergleichen.

6. Schaltung nach Anspruch 1, dadurch gekennzeichnet, dass besagte Kapazität (C$_2$) an den Sender eines fünften Transistors (T$_5$) angeschlossen ist, der angelegt ist, um die von der Sekundärwicklung (n$_2$) des Transformators (TC) während der Zeiträume zwischen den Impulsen hervorgebrachte Sperrspannung mit der eigenen Basis-Senderspannung zu vergleichen und besagte negative Vorspannung an die Basis des ersten Transistors (T$_6$) während der besagten Zwischenzeiten anzulegen.

7. Schaltung nach Anspruch 5, dadurch gekennzeichnet, dass besagte Mittel, um eine für den Strom des ersten Transistors (T$_6$) repräsentative Spannung zu entnehmen, einen einstellbaren Widerstand (R$_{16}$) beinhalten, der an den Sender des besagten ersten Transistors (T$_6$) angeschlossen ist, einen zweiten Widerstand (R$_{15}$), der den Sender des ersten Transistors (T$_6$) mit der Basis des vierten Transistors (T$_3$) verbindet, sowie eine Schaltung, welche die Basis des vierten Transistors (T$_3$) mit seinem Sender verbindet, wobei diese Schaltung in Reihe enthält: einen einstellbaren Widerstand (R$_{13}$) und einen Widerstand mit negativem Temperaturkoeffizienten (CTN), der die Basis-Senderspannungsschwankungen des besagten vierten Transistors (T$_3$) ausgleichen soll.

8. Schaltung nach Anspruch 5, dadurch gekennzeichnet, dass die Basis des vierten Transistors (T$_3$) durch einen Widerstand (R$_x$) an eine Klemme (+ Vce) angeschlossen ist, an die eine Spannung angelegt wird, welche repräsentativ ist für die Kollektor-Senderspannung des ersten Transistors (T$_6$).

9. Schaltung nach Anspruch 5, dadurch gekennzeichnet, dass die Basis des vierten Transistors (T$_3$) durch Differenziermittel (R$_{12}$, C$_3$, C$_4$) an die Basis des besagten fünften Transistors (T$_5$) angeschlossen ist, um die Leitfähigkeit des besagten fünften Transistors (T$_5$) zu beschleunigen, wenn der vierte Transistor (T$_3$) selbst leitend wird.

10. Schaltung nach Anspruch 5, dadurch gekennzeichnet, dass sie einen Widerstand (R$_{10}$) beinhaltet, welcher den Kollektor des dritten Transistors (T$_4$) mit der Basis des vierten Transistors (T$_3$) verbindet, damit besagter vierter Transistor (T$_3$) leitend wird, sobald der dritte Transistor (T$_4$) es nicht mehr ist.

**Claims**

1. A circuit for controlling the base of a first power transistor (T$_6$) comprising a pulse transformer (TC) having a primary winding and a secondary winding connected to the base of said first transistor (T$_6$) by means of a first switching device (T$_2$) made conducting for the duration of the pulses, so as to obtain a quasi-saturated state of said first transistor (T$_6$) during said duration, characterized in that it further comprises a means for counter-biassing said base, which comprise at least one capacity (C$_2$), a circuit for charging said capacity (C$_2$), from the secondary winding of the transformer (TC), to a voltage corresponding to a disabling voltage of the first transistor (T$_6$), and a connection circuit connecting said capacity (C$_2$) to the base of said transistor (T$_6$), this connection circuit comprising a second switching device (T$_5$) made conducting during the intervals between said pulses.

2. The circuit according to claim 1, characterized in that it further comprises means (R$_{16}$, CO$_1$, B, P) for taking off a voltage representative of the current which flows in said first transistor (T$_6$), comparing it with a threshold (S$_1$) and interrupting the conduction of said first switching device (T$_2$) should said threshold (S$_1$) be exceeded.

3. The circuit according to claim 1, characterized in that the control terminal of said first switching device (T$_2$) is connected to the output of a memory latch with dominant reset (B) whose set input (S) receives the voltage fronts emitted by the secondary winding (n$_2$) of the transformer (TC) and whose reset input (R) is connected to the output of a threshold device (CO$_1$) which receives at one of its inputs a DC threshold voltage (S$_1$) and at its other input a voltage representative of the current flowing in the first transistor (T$_6$).

4. The circuit according to claim 1, characterized in that the circuit for charing said capacity (C$_2$) comprises a resistor (R$_{17}$) in series with the secondary winding (n$_2$) of the transformer (TC) and to the terminals of which there is connected in parallel a circuit comprising in series a diode (D$_8$) and said capacity (C$_2$).

5. The circuit according to claim 3, characterized in that said first switching device consists of a sec-

ond transistor ($T_2$) and in that the memory latch with dominant reset (B) comprises a third transistor ($T_4$) connected by its collector to the base of the second transistor ($T_2$) and whose base is connected to its own emitter through the emitter-collector junction of a fourth transistor ($T_3$) playing the role of a comparator, whose base is connected to means ($R_{15}$, $R_{16}$) for taking off a voltage representative of the current delivered by the first transistor ($T_6$) and comparing said voltage with its base-emitter voltage.

6. The circuit according to claim 1, characterized in that said capacity ($C_2$) is connected to the emitter of a fifth transistor ($T_5$) adapted for comparing the reverse voltage generated by the secondary winding ($n_2$) of the transformer (TC) during the intervals between the pulses with its own base-emitter voltage and applying said negative bias voltage to the base of the first transistor ($T_6$) during said intervals.

7. The circuit according to claim 5, characterized in that said means for taking off a voltage representative of the current of the first transistor ($T_6$) comprise an adjustable resistor ($R_{16}$) connected to the emitter of said first transistor ($T_6$), a second resistor ($R_{15}$) connecting the emitter of the first transistor ($T_6$) to be base of the fourth transistor ($T_3$), as well as a circuit connecting the base of the fourth transistor ($T_3$) to its emitter, this circuit comprising, in series, an adjustable resistor ($R_{13}$) and a resistor with negative temperature coefficient (CTN), chosen for compensating the variations in the base-emitter voltage of said fourth transistor ($T_3$).

8. The circuit according to claim 5, characterized in that the base of the fourth transistor ($T_3$) is connected through a resistor ($R_X$) to a terminal ( +Vce) brought to a voltage representative of the collector-emitter voltage of the first transistor ($T_6$).

9. The circuit according to claim 5, characterized in that the base of the fourth transistor ($T_3$) is connected by deriver means ($R_{12}$, $C_3$, $C_4$) to the base of said fifth transistor ($T_5$) so as to accelerate the enabling of said fifth transistor ($T_5$) when the fourth transistor ($T_3$) is itself enabled.

10. The circuit according to claim 5, characterized in that it comprises a resistor ($R_{10}$) connecting the collector of the third transistor ($T_4$) to the base of the fourth transistor ($T_3$) so as to ensure conduction of said fourth transistor ($T_3$) as soon as the third transistor ($T_4$) ceases conducting.

# FIG. 1

0 114 540

FIG. 2

FIG. 3

Vin

R3
R4
D5
V2
D4
D3
Z
+Vce
C6
Ic
IB
T6
R19
D9
R5
T2
D6
R6
TC
n1
n2
R7
R8
R9
I2
I2
I1
R11
T4
R10
+Vce
Rx
R15
T3
R13
R12
R14
C1
R16
CTN
R17
0Vce
D1
D2
R1
T1
R2
C2
C3
R18
T5
C4
D8
0Vs

13

0 114 540